# DEMANDE DE BREVET EUROPEEN

(11) **EP 1 422 314 A1**
(43) Date de publication de la demande: **26.05.2004**
(21) Numéro de dépôt: 03292742.8
(22) Date de dépôt: 04.11.2003
(51) Int. Cl.: C23C 14/56, C23C 16/44, H01L 21/00

(54) **Dispositif et procédé de nettoyage des chambres de procédés et lignes de vide**

(30) Priorité: 21.11.2002 FR 0214571
(71) Demandeur: ALCATEL, 75008 Paris (FR)
(72) Inventeur: Kambara, Hisanori, 74350 Villy-le-Pelloux (FR)
(74) Mandataire: Lamoureux, Bernard

(57) **Abrégé**

Selon l'invention, on contrôle l'état d'avancement des étapes de nettoyage de la chambre de procédés (1) en mesurant l'état de propreté d'un échantillon de surface (6) intérieure de la chambre de procédés (1). Pour cela, l'échantillon de surface (6) est tantôt soumis à l'action des gaz de nettoyage dans la chambre de procédés (1), tantôt soumis à l'action d'un plasma de test (5) généré par une source de plasma de test (3) communiquant par une interface (4). Le plasma de test (5) excite les atomes sur l'échantillon de surface (6), et produit un rayonnement mesuré par un spectromètre (7) qui envoie des signaux à des moyens de commande (9) permettant de fermer une électrovanne (10) d'amenée de gaz de nettoyage dans la chambre de procédés (1) lorsque le nettoyage est suffisant. On évite ainsi un nettoyage excessif, trop long et susceptible de dégrader la surface intérieure de la chambre de procédés (1) ou de la ligne de vide (2).

## Description

L'invention présentée dans ce document concerne le nettoyage des chambres de procédés et lignes de vide dans les installations de fabrication de composants à semi-conducteur et de composants de microtechnique.

La fabrication de composants à semi-conducteur et de composants de microtechnique est habituellement réalisée sous vide dans une chambre de procédés. Cette fabrication comprend de nombreuses étapes, notamment des étapes de dépôt chimique sous forme de vapeur (CVD), dans lesquelles un ou plusieurs corps gazeux réagissent sur une surface solide pour produire un dépôt en phase solide. On peut ainsi déposer sur un substrat de semi-conducteur diverses couches solides, par exemple pour réaliser des circuits électriques. Toutefois, les dépôts solides se produisent non seulement sur le substrat de semi-conducteur, mais également sur toute la paroi de la chambre de procédés, et sur la paroi de la ligne de vide qui génère et maintient le vide dans la chambre de procédés.

Une même chambre de procédés est utilisée successivement pour la fabrication de plusieurs lots de composants, par dépôts successifs sur des lots de tranches de semi-conducteur. Or le dépôt solide appliqué sur la paroi de la chambre de procédés lors de la procédure de fabrication d'un lot de composants est susceptible de contaminer les tranches de semi-conducteur d'un autre lot qui est ultérieurement introduit dans la chambre pour une seconde procédure de traitement. Il est donc nécessaire de conserver la pureté de la chambre de procédés, pour éviter ces contaminations d'une procédure à l'autre. On procède à un nettoyage des chambres de procédés entre deux procédures de fabrication successives.

Par exemple, dans le procédé de dépôt chimique à haute densité (HDPCVD) il se produit un dépôt solide d'oxyde de silicium (SiO₂), que l'on enlève en utilisant le trifluorure d'azote (NF₃) qui est un gaz hautement réactif. Les molécules de NF₃ sont dissociées par le plasma pour produire des molécules F₂ et des atomes excités de fluor atomique F. Les atomes de fluor réagissent avec l'oxyde de silicium pour produire du tétrafluorure de silicium (SiF₄) et d'autres molécules gazeuses. Ces gaz sont pompés hors de la chambre de procédés par la ligne de vide. Actuellement, une procédure de dépôt HDPCVD dure plusieurs minutes pour créer une couche de 7 500 Å d'oxyde de silicium sur une tranche de silicium. L'étape de nettoyage entre deux procédures de dépôt prend à nouveau plusieurs minutes pour enlever la couche indésirable d'oxyde de silicium sur la paroi de la chambre de procédés. On ajuste la période de nettoyage, afin qu'elle soit juste suffisante pour enlever la couche de silicium de la paroi de la chambre de procédés sans attaquer sensiblement le métal de la paroi de chambre de procédés.

L'ajustement de la durée de la période de nettoyage s'effectue actuellement par tâtonnements, de façon à déterminer expérimentalement à l'issue de plusieurs essais la durée approximative convenant au procédé utilisé. Un ajustement doit être effectué pour chaque type de procédé utilisé. La méthode est fastidieuse, et ne permet pas de compenser rapidement et efficacement les variantes, adaptations ou dérives éventuelles des procédés.

On a également proposé, dans le document US 2002/0020429 A1, de réaliser le nettoyage d'une chambre de procédés en utilisant une source de plasma distante qui est moins agressive pour les organes internes de la chambre de procédés.

Le document propose de déterminer la fin de l'étape de nettoyage (endpoint) par une source secondaire de plasma de test, placée directement dans la chambre de procédés pour générer un plasma à partir des gaz présents dans la chambre de procédés, et associée à des moyens d'analyse spectroscopique du plasma de test ainsi généré. Le plasma de test n'agit pas sur les parois de la chambre de procédés, et sa puissance doit être suffisamment faible pour ne pas affecter l'opération de nettoyage assurée par la source de plasma distante.

On considère que le nettoyage est achevé lorsque les moyens d'analyse spectroscopique indiquent que l'intensité des espèces ou des sous-produits, ou leur rapport, atteint un palier de niveau prédéterminé et stable, indiquant que la chambre est complètement propre.

Cette technique est une méthode indirecte, qui constate l'absence de sous-produit de nettoyage dans le plasma de nettoyage généré par la source de plasma distante.

L'information donnée par le générateur de plasma de test n'est pas fiable, car le résultat dépend aussi de la source de plasma distante elle-même, et de sa capacité à assurer un nettoyage. De plus, la méthode ne donne une information qu'après le nettoyage complet de la chambre de procédés, et ne peut pas donner d'information sur la progression d'une étape de nettoyage en cours. Il en résulte aussi que la méthode manque de précision.

Le problème est de déterminer de façon rapide, efficace et fiable le temps nécessaire pour nettoyer la chambre de procédés de façon suffisante et sans excès. Une durée de nettoyage sous-évaluée ne permet pas d'enlever complètement la couche d'oxyde de silicium sur la paroi de chambre de procédés. A l'inverse, une durée de nettoyage surévaluée provoque la réaction des atomes de fluor avec le métal de la paroi de chambre de procédés elle-même.

En outre, le gaz de nettoyage NF₃ est un gaz onéreux, dont il y a intérêt à minimiser la quantité utilisée. Un cycle de nettoyage utilise environ 3,5 litres de NF₃, et ce gaz coûte environ 400 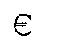 par kilogramme. Une cassette contient 25 tranches de silicium, et on utilise une bouteille de 22 kg de NF₃ pour nettoyer la chambre pendant la fabrication de 84 cassettes. Cela correspond à un coût d'environ 100 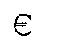 par cassette pour le nettoyage. Ce coût n'est pas négligeable, et il y a un intérêt à réduire ce coût.

En outre, le gaz de nettoyage NF₃ est un gaz biologiquement nuisible, de sorte qu'il y a un intérêt écologique à réduire la quantité utilisée, pour éviter de dégrader l'environnement.

L'invention vise à contrôler le nettoyage des chambres de procédés et lignes de vide, pour assurer un nettoyage juste suffisant des chambres de procédés et lignes de vide, évitant ainsi à la fois une insuffisance de nettoyage et un excès de nettoyage. On assure ainsi une bonne qualité des procédés de traitement dans la chambre de procédés, tout en minimisant les quantités de gaz de nettoyage utilisées. Le contrôle doit être à la fois rapide, efficace et fiable, de façon à permettre une adaptation à tous types de procédés, et à assurer une grande flexibilité des procédés.

Grâce à un tel contrôle de nettoyage, on peut à la fois dépenser moins de gaz de nettoyage, et éviter la dégradation des parois de chambres de procédés et lignes de vide.

On peut également automatiser le nettoyage, en évitant d'avoir recours à l'expérience des utilisateurs compétents pour le choix d'une durée satisfaisante de nettoyage.

L'idée essentielle de l'invention est de concevoir un dispositif permettant de déterminer directement l'état de propreté d'une chambre de procédés ou ligne de vide, le dispositif étant ainsi utilisé pour commander la poursuite de l'étape de nettoyage tant que la chambre de procédés ou la ligne de vide n'est pas suffisamment nettoyée, et pour interrompre l'étape de nettoyage dès que la chambre de procédés ou la ligne de vide est suffisamment nettoyée.

Pour cela, un capteur vient tester la nature de la couche de surface d'un échantillon de surface intérieure de paroi de la chambre de procédés ou ligne de vide, pour détecter la présence ou l'absence d'atomes d'une couche de dépôt.

Pour atteindre ces buts ainsi que d'autres, l'invention prévoit un dispositif de contrôle de nettoyage des chambres de procédés et lignes de vide, comprenant une source de plasma de test, des moyens de mesure d'émission spectrale recevant le rayonnement lumineux du plasma de test, des moyens d'analyse des signaux obtenus des moyens de mesure d'émission spectrale pour déterminer la nature des atomes présents dans le plasma de test, et des moyens pour soumettre alternativement un échantillon de surface intérieure de chambre de procédés ou de ligne de vide à contrôler, soit aux gaz régnant à l'intérieur de la chambre de procédés ou ligne de vide, soit au plasma de test de la source de plasma de test.

Le plasma de test agit sur l'échantillon de surface à tester, en prélevant des atomes de surface. Dans le plasma de test, ces atomes sont excités, et émettent des photons selon un spectre correspondant à l'énergie de transition qui est spécifique à chaque atome. En utilisant des moyens de mesure d'émission spectrale, il est ainsi possible d'identifier les atomes en analysant le spectre optique émis, et le nombre de photons émis est proportionnel au nombre d'atomes présents dans l'échantillon analysé.

L'échantillon est représentatif de l'état de la totalité de la surface intérieure de la chambre de procédés. On réalise donc une méthode de contrôle directe, fiable et précise.

Le dispositif de contrôle est relativement volumineux, et il est exclu de le placer entièrement et en permanence à l'intérieur d'une chambre de procédés pour le diriger vers l'échantillon de surface intérieure à analyser. Il faut donc prévoir une interface qui, à partir des moyens externes de mesure d'émission spectrale, assure une liaison intermittente avec l'échantillon de surface à analyser qui est nécessairement orienté vers l'intérieur de la chambre de procédés.

Un premier mode de réalisation consiste à prévoir un échantillon de surface à analyser mobile, installé dans la chambre de procédés ou ligne de vide et déplaçable entre un premier état dans lequel la surface active de l'échantillon de surface à analyser est orientée vers l'intérieur de la chambre de procédés ou ligne de vide pour être soumise aux gaz de la chambre de procédés ou ligne de vide et pour recevoir les dépôts, et un second état d'échantillonnage dans lequel la surface active de l'échantillon de surface à analyser est orientée vers l'extérieur de la chambre de procédés ou ligne de vide, face à la source de plasma de test, pour être soumise au plasma de test. En première position, l'échantillon de surface reçoit le dépôt, comme toutes les autres zones de surface intérieure de chambre de procédés ou ligne de vide. En seconde position, l'échantillon de surface est accessible pour être soumis au plasma de test.

Un second mode de réalisation consiste à prévoir une fibre optique flexible entre les moyens externes de mesure d'émission spectrale et une source de plasma de test déplaçable dans la chambre de procédés ou ligne de vide, permettant ainsi de diriger le plasma de test à des instants prédéterminés vers une zone de surface intérieure de la paroi de chambre de procédés ou de ligne de vide. La source de plasma de test prend un premier état à l'écart de l'échantillon de surface à analyser pour laisser agir sur l'échantillon de surface à analyser les gaz de la chambre de procédés ou ligne de vide, et prend un second état au regard de l'échantillon de surface à analyser pour faire agir sur l'échantillon de surface à analyser le plasma de test.

De préférence, le dispositif selon l'invention comprend des moyens de commande pour recevoir, en provenance des moyens d'analyse, les informations relatives à la nature des atomes présents dans le plasma de test, pour commander la poursuite de l'étape de nettoyage tant que les atomes présents comprennent des atomes de dépôt, et pour interrompre l'étape de nettoyage dès que les atomes présents ne comprennent plus d'atomes de dépôt.

L'invention prévoit également un procédé de nettoyage de chambres de procédés ou lignes de vide, comprenant une étape de nettoyage dans laquelle on fait agir un ou plusieurs gaz de nettoyage assurant la décomposition des dépôts sur les parois intérieures des chambres de procédés ou lignes de vide ; on prévoit une ou plusieurs étapes intermédiaires de contrôle dans lesquelles, au moyen d'un dispositif de contrôle défini ci-dessus, on recherche la présence d'atomes de dépôt sur au moins un échantillon de surface intérieure de la chambre de procédés ou ligne de vide à nettoyer en faisant agir un plasma de test sur le dépôt de l'échantillon de surface.

Les étapes intermédiaires de contrôle peuvent être réalisées à des instants prédéterminés.

Les instants prédéterminés sont, de préférence, choisis au voisinage de l'instant prévisible de fin de nettoyage.

D'autres objets, caractéristiques et avantages de la présente invention ressortiront de la description suivante de modes de réalisation particuliers, faite en relation avec les figures jointes, parmi lesquelles :
- la figure 1 est une vue schématique d'ensemble d'une chambre de procédés et de ses moyens de contrôle, avec dispositif de contrôle de nettoyage selon un mode de réalisation de la présente invention ;
- la figure 2 est une vue schématique partielle d'un premier mode de réalisation du dispositif de contrôle selon l'invention, illustré en position de nettoyage ;
- la figure 3 est une vue partielle schématique du dispositif de contrôle de la figure 2, illustré en position de test ;
- la figure 4 est une vue schématique des moyens de test et de commande selon un mode de réalisation de la présente invention ;
- la figure 5 est une vue schématique partielle d'un dispositif de contrôle selon un second mode de réalisation, illustré en position de test ; et
- la figure 6 est une vue partielle du dispositif de contrôle de la figure 5, illustré en position de nettoyage.

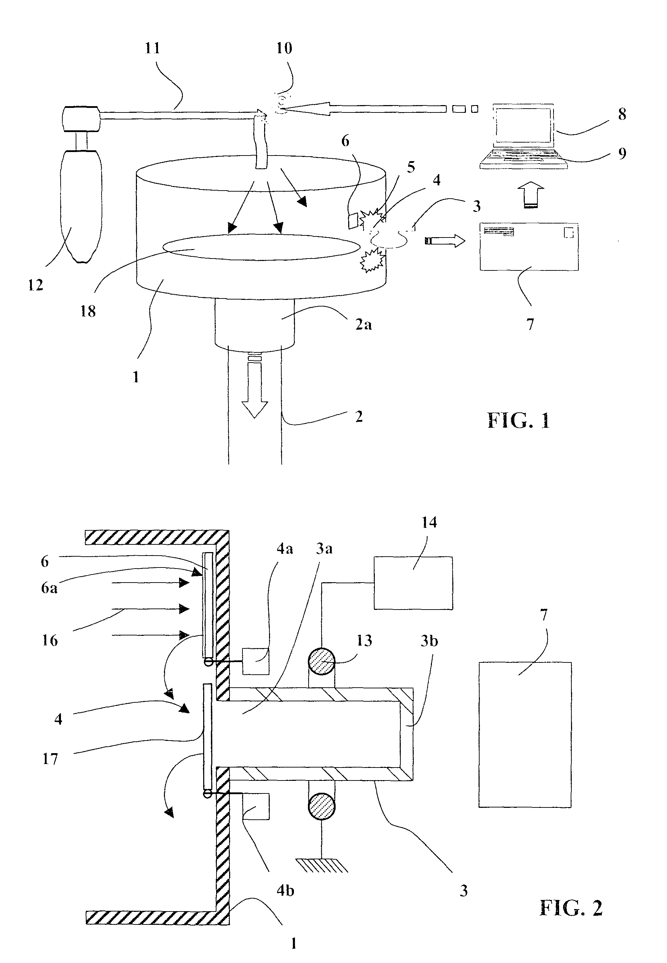

Dans la réalisation illustrée sur la figure 1, le dispositif de contrôle est appliqué à une chambre de procédés 1 associée à une ligne de vide 2 comprenant des moyens de pompage 2a pour pomper les gaz hors de la chambre de procédés 1.

Le dispositif de contrôle comprend une source de plasma de test 3 permettant de générer un plasma de test 5. Une interface 4 permet de diriger le plasma de test 5 vers un échantillon de surface 6 intérieure de la chambre de procédés 1 ou de la ligne de vide 2 à contrôler. Des moyens de mesure d'émission spectrale 7 du plasma de test 5 permettent de mesurer l'émission spectrale du plasma de test 5.

Les signaux produits par les moyens de mesure d'émission spectrale 7 sont envoyés à des moyens d'analyse 8 permettant d'analyser les signaux obtenus pour déterminer la nature des atomes présents dans le plasma de test 5.

Des moyens de commande 9 reçoivent les signaux en provenance des moyens d'analyse 8, et permettent de commander la poursuite ou l' arrêt de l'étape de nettoyage de la chambre de procédés 1 ou de la ligne de vide 2. Pour cela, les moyens de commande 9 commandent des électrovannes 10 placées dans une canalisation d'amenée de gaz de nettoyage 11 pour conduire des gaz de nettoyage provenant d'une source de gaz de nettoyage 12 jusque dans la chambre de procédés 1.

Selon l'invention, on prévoit des moyens pour soumettre alternativement l'échantillon de surface 6 soit aux gaz régnant à l' intérieur de la chambre de procédés 1 ou ligne de vide 2, soit au plasma de test 5 de la source de plasma de test 3 par l'intermédiaire de l'interface 4.

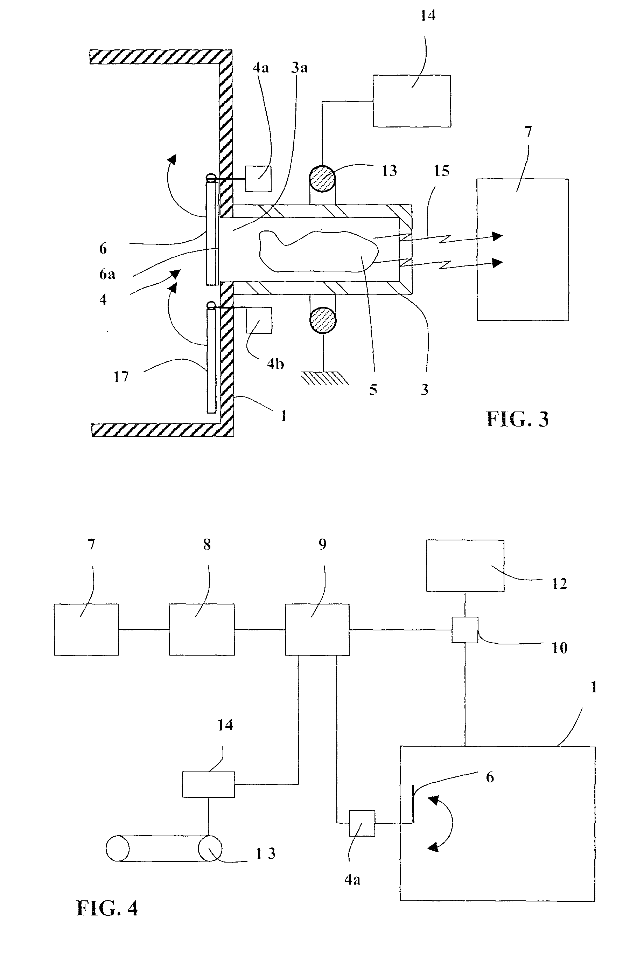

La source de plasma de test 3 est illustrée plus en détail selon un mode de réalisation particulier, sur les figures 2 et 3. Il peut s'agir d'un générateur de plasma.

Dans ce mode de réalisation, la source de plasma de test 3 comprend un tube de quartz étanche ayant une première extrémité 3a communiquant avec l'atmosphère intérieure de la chambre de procédés 1 ou de la ligne de vide 2 à tester, et ayant une seconde extrémité 3b borgne. Le tube est entouré d'une antenne d'excitation magnétique 13, associée à un générateur radiofréquence 14 qui l'alimente en énergie électrique radiofréquence pour générer dans le tube un plasma de test 5 (figure 3).

Un tel générateur de plasma peut fonctionner dans une plage de pressions gazeuses internes allant généralement de 100 Pa à 1000 Pa.

Les moyens de mesure d'émission spectrale 7, par exemple constitués d'un spectromètre d'émission, sont placés au regard de l'extrémité borgne 3b du tube de la source de plasma de test 3, pour recevoir à travers la paroi du tube le rayonnement lumineux 15 émis par le plasma de test 5 présent dans le tube.

Ainsi, la paroi du tube de quartz étanche est traversée par le rayonnement lumineux 15 se propageant depuis le plasma de test 5 jusqu'aux moyens de mesure d'émission spectrale 7.

On considère maintenant le premier mode de réalisation de l'interface 4 tel que décrit en relation avec les figures 2 et 3. Dans ce premier mode de réalisation, l'interface 4 permet de déplacer un échantillon de surface 6 intérieure de la chambre de procédés 1 à contrôler entre un premier état illustré sur la figure 2 et un second état illustré sur la figure 3.

Dans le premier état illustré sur la figure 2, l'échantillon de surface 6 est orienté vers l'intérieur de la chambre de procédés 1 ou de la ligne de vide 2 à contrôler, et est ainsi soumis aux gaz 16 de la chambre de procédés 1 ou de la ligne de vide 2, par exemple au gaz de nettoyage tel que NF₃. De la sorte, pendant les étapes actives du procédé, l'échantillon de surface 6 est soumis au plasma actif dans la chambre de procédés 1, lequel plasma génère un dépôt 6a sur toute la surface intérieure de la chambre de procédés 1, et en particulier sur l'échantillon de surface 6. Ensuite, pendant une étape de nettoyage de la chambre de procédés 1, l'échantillon de surface 6 est soumis à l'action des gaz de nettoyage 16 dont la présence vise à éliminer le dépôt 6a. L'objet de l'invention est précisément de détecter l'instant à partir duquel le dépôt 6a a disparu du fait de l'action des gaz de nettoyage 16.

Dans le second état, illustré sur la figure 3, l'échantillon de surface 6 est orienté vers l'extérieur de la chambre de procédés 1 ou de la ligne de vide 2, face à la source de plasma de test 3 pour être soumis au plasma de test 5. De la sorte, le plasma de test 5 décroche de l'échantillon de surface 6 les éventuels atomes du dépôt 6a, ces atomes générant des émissions spectrales qui sont contenues dans le rayonnement lumineux 15 se propageant vers les moyens de mesure d'émission spectrale 7.

Dans tous les modes de réalisation, l'échantillon de surface 6 peut avoir une taille réduite, par exemple de seulement quelques millimètres.

Dans le mode de réalisation des figures 2 et 3, l'interface 4 comprend en outre éventuellement un volet de fermeture 17, mobile entre une position de fermeture de la première extrémité 3a de la source de plasma de test 3 lors des étapes de nettoyage ou des étapes actives des procédés, et une position d'ouverture de la première extrémité 3a lors des étapes de test telles qu'illustrées sur la figure 3.

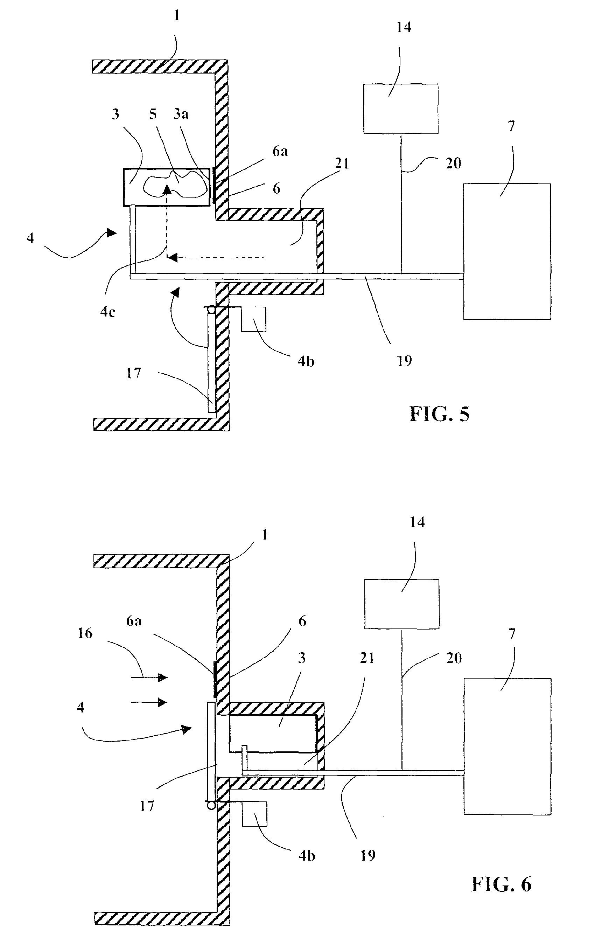

Dans le second mode de réalisation illustré sur les figures 5 et 6, la source de plasma de test 3 est elle-même déplaçable dans la chambre de procédés 1 ou la ligne de vide 2, prenant un premier état illustré sur la figure 6 et un second état illustré sur la figure 5.

Dans ce mode de réalisation, on retrouve une source de plasma de test 3, illustrée schématiquement sous forme d'un tube ayant une première extrémité 3a pour communiquer avec l'atmosphère intérieure de la chambre de procédés 1 ou ligne de vide à tester, et avec une antenne d'excitation magnétique non représentée qui est alimentée en énergie électrique radiofréquence par le générateur radiofréquence 14.

On retrouve les moyens de mesure d'émission spectrale 7, par exemple un spectromètre d'émission.

Dans le premier état illustré sur la figure 6, la source de plasma de test 3 est à l'écart de l'échantillon de surface 6 à analyser, qui est alors une portion de la paroi de la chambre de procédés 1 ou ligne de vide. Dans cet état, les gaz de la chambre de procédés 1 ou ligne de vide agissent sur l'échantillon de surface 6 à analyser. Par exemple, les gaz de nettoyage 16 réduisent progressivement le dépôt 6a sur l'échantillon de surface à analyser 6 pendant l'étape de nettoyage.

Dans le second état illustré sur la figure 5, la source de plasma de test 3 est à l'intérieur de la chambre de procédés 1 ou ligne de vide, au regard de l'échantillon de surface 6 à analyser, pour faire agir sur l'échantillon de surface 6 à analyser le plasma de test 5 généré par l'alimentation de l'antenne d'excitation magnétique par le générateur radiofréquence 14.

Pour permettre les déplacements de la source de plasma de test 3 entre les deux états du dispositif de contrôle, celle-ci est reliée aux moyens de mesure d'émission spectrale 7 par une fibre optique flexible 19, qui conduit le rayonnement lumineux depuis la source de plasma de test 3 jusqu'aux moyens de mesure d'émission spectrale 7. La fibre optique flexible 19 est associée à la ligne d'alimentation électrique flexible 20 qui conduit l'énergie électrique radiofréquence depuis le générateur radiofréquence 14 jusqu'à l'antenne d'excitation magnétique de la source de plasma de test 3.

Dans le premier état illustré sur la figure 6, la source de plasma de test 3 est logée dans un compartiment 21 isolé de l'action des plasmas ou gaz de nettoyage 16 à l'intérieur de la chambre de procédés 1 par le volet de fermeture 17 actionné par les moyens d'actionnement 4b tels qu'un moteur ou un vérin. Dans le second état illustré sur la figure 5, la source de plasma de test 3 est déplacée à l'intérieur de la chambre de procédés 1 après ouverture du volet de fermeture 17 par actionnement des moyens d' actionnement 4b. Pour son déplacement, la source de plasma de test est sollicitée par des moyens de déplacement 4c tels que des vérins, simplement illustrés sur la figure 5 par des flèches.

Dans les deux modes de réalisation, des moyens d'actionnement 4a et 4b, et éventuellement des moyens de déplacement 4c, tels que des moteurs ou vérins, permettent de faire passer le dispositif de contrôle entre ses premier et second états.

Par exemple, dans le mode de réalisation des figures 2 et 3, les moyens d'actionnement comprennent un premier élément 4a, tel qu'un vérin, pour faire pivoter l'échantillon de surface 6 entre la position de premier état illustrée sur la figure 2 et la position de second état illustrée sur la figure 3, tandis qu'un second élément 4b tel qu'un second vérin permet de faire pivoter le volet de fermeture 17 entre le premier état illustré sur la figure 2 et le second état illustré sur la figure 3.

Dans le second mode de réalisation des figures 5 et 6, on retrouve le volet de fermeture 17 et son moyen d'actionnement 4b pour ouvrir ou fermer le compartiment 21 d'isolement de la source de plasma de test 3, ladite source de plasma de test 3 étant déplacée par des moyens de déplacement 4c entre ses deux états illustrés respectivement sur les figures 6 et 5.

En fonctionnement, la chambre de procédés telle qu'illustrée sur la figure 1 reçoit une ou plusieurs tranches de semi-conducteur 18. Lors des étapes actives de procédés, les tranches de semi-conducteur 18 subissent des étapes de dépôt chimique, des étapes de gravure et autres étapes dans lesquelles on fait agir des plasmas actifs générés par une source principale de plasma dans la chambre de procédés 1. Ces étapes produisent, sur toute la surface intérieure de la chambre de procédés 1 et notamment sur l'échantillon de surface 6, des dépôts solides tels que le dépôt 6a.

Pour éviter la pollution ultérieure des tranches de semi-conducteur 18 par ces dépôts susceptibles d'être à nouveau libérés dans l'atmosphère intérieure de la chambre de procédés 1, on procède à des étapes de nettoyage au cours desquelles on fait réagir un ou plusieurs gaz de nettoyage 16, en admettant dans la chambre de procédés 1 un gaz de nettoyage provenant de la source de gaz de nettoyage 12, par l'ouverture de l'électrovanne 10 et l'écoulement du gaz de nettoyage par la canalisation d'amenée des gaz de nettoyage 11. L'ouverture de l'électrovanne 10 est assurée par les moyens de commande 9.

Le gaz de nettoyage 16 produit alors un nettoyage progressif de la surface intérieure de la chambre de procédés 1, notamment de l'échantillon de surface 6.

Tant pendant les étapes actives du procédé que pendant les étapes de nettoyage, l'interface 4 est dans son premier état dans lequel l'échantillon de surface 6 est soumis à l'action des plasmas actifs ou des plasmas de nettoyage dans la chambre de procédés 1.

On prévoit, pendant la phase de nettoyage, une ou plusieurs étapes intermédiaires de contrôle au moyen des dispositifs de contrôle tels que décrits précédemment, et on recherche la présence d'atomes de dépôt sur l'échantillon de surface 6. Pour cela, à chaque étape intermédiaire de contrôle, les moyens de commande 9 provoquent le fonctionnement des moyens d'actionnement 4a et 4b et éventuellement des moyens de déplacement 4c pour faire passer l'interface 4 de son premier état vers son second état, pour que l'échantillon de surface 6 soit soumis à l'action du plasma de test 5.

Par exemple, sur les figures 2 et 3, les moyens d'actionnement 4a et 4b font pivoter l'échantillon de surface 6 vers la source de plasma de test 3, et font pivoter le volet de fermeture 17 à l'écart de la source de plasma de test 3. Sur les figures 5 et 6, les moyens de déplacement 4c déplacent la source de plasma de test 3 de son premier état illustré sur la figure 6 vers son second état illustré sur la figure 5 et les moyens d'actionnement 4b font pivoter le volet de fermeture 17.

Ensuite, au cours de l'étape intermédiaire de contrôle, les moyens de commande 9 provoquent le fonctionnement du générateur radiofréquence 14 qui excite les gaz à l'intérieur du tube de la source de plasma de test 3 pour générer le plasma de test 5. Le plasma de test 5 agit alors sur le dépôt 6a de l'échantillon de surface 6, libérant des atomes qui sont alors excités et produisent un rayonnement lumineux 15 perçu par les moyens de mesure d'émission spectrale 7. Les moyens de mesure d'émission spectrale 7 envoient alors des signaux aux moyens d'analyse 8 qui déterminent la nature des atomes présents dans le plasma de test et communiquent cette information aux moyens de commande 9.

Si les signaux indiquent la présence d'atomes de dépôt, les moyens de commande 9 poursuivent l'étape de nettoyage, après avoir agi sur les moyens d'actionnement 4a et 4b pour ramener l'interface 4 dans son premier état et pour soumettre ainsi l'échantillon de surface 6 à l'action des gaz de nettoyage 16, pendant une durée déterminée à l'issue de laquelle on recommence une étape intermédiaire de contrôle dans les mêmes conditions que ci-dessus.

Si, lors d'une étape intermédiaire de contrôle, les moyens de commande 9 reçoivent l'information selon laquelle il n'y a plus d'atomes de dépôt, alors les moyens de commande 9 actionnent l'électrovanne 10 pour interrompre l'admission des gaz de nettoyage et mettre fin à l'étape de nettoyage. Les moyens de commande ramènent ensuite l'interface 4 dans son premier état, afin que la chambre de procédés 1 soit remise dans son état de fonctionnement pour les étapes actives des procédés.

Lors des étapes intermédiaires de contrôle, il est également possible de détecter que la quantité d'atomes de dépôt devient inférieure à un seuil prédéterminé, indiquant que le nettoyage est bientôt terminé. Dans ce cas, les moyens de commande 9 peuvent simplement poursuivre l'étape de nettoyage pendant une durée prédéterminée, estimée pour que le nettoyage soit suffisant et soit alors interrompu.

La figure 4 illustre le schéma général des organes d'actionnement du dispositif des figures 1 à 3 et 5 et 6.

On retrouve ainsi les moyens de mesure d'émission spectrale 7, tels qu'un spectromètre d'émission, qui envoient leurs signaux de sortie aux moyens d'analyse 8 qui déterminent la nature des atomes présents dans le plasma de test 5. Les moyens d'analyse envoient leurs signaux aux moyens de commande 9 qui agissent d'une part sur l'électrovanne 10 pour poursuivre ou interrompre l'étape de nettoyage, et qui agissent sur les moyens d'actionnement ou de déplacement 4a (et/ou 4b et/ou 4c) pour modifier l'état du dispositif de contrôle dans la chambre de procédés 1. Les moyens de commande 9 agissent également sur le générateur radiofréquence 14 pour alimenter l'antenne d'excitation magnétique 13 qui excite les atomes de gaz dans la source de plasma de test 3 pour générer le plasma de test 5.

Grâce à l'invention, on peut contrôler efficacement le nettoyage des chambres de procédés et lignes de vide, en assurant de préférence un nettoyage suffisant mais non excessif, quel que soit le procédé ayant précédemment généré le dépôt à nettoyer, et quel que soit le procédé de nettoyage.

La présente invention n'est pas limitée aux modes de réalisation qui ont été explicitement décrits, mais elle en inclut les diverses variantes et généralisations qui sont à la portée de l'homme du métier.

## Revendications

1. Dispositif de contrôle de nettoyage des chambres de procédés (1) et lignes de vide (2), comprenant une source de plasma de test (3), des moyens de mesure d'émission spectrale (7) recevant le rayonnement lumineux du plasma de test (5), et des moyens d'analyse (8) des signaux obtenus des moyens de mesure d'émission spectrale (7) pour déterminer la nature des atomes présents dans le plasma de test (5), **caractérisé en ce qu'**il comprend en outre des moyens (4) pour soumettre alternativement un échantillon de surface (6) intérieure de chambre de procédés ou ligne de vide (2) à contrôler soit au gaz régnant à l'intérieur de la chambre de procédés (1) ou ligne de vide (2), soit au plasma de test (5) de la source de plasma de test (3).

2. Dispositif selon la revendication 1, **caractérisé en ce que** l'échantillon de surface (6) à analyser est mobile, prenant un premier état orienté vers l'intérieur de la chambre de procédés (1) ou ligne de vide (2) pour être soumis aux gaz de la chambre de procédés (1) ou ligne de vide (2), et prenant un second état orienté vers l'extérieur de la chambre de procédés (1) ou ligne de vide (2) face à la source de plasma de test (3) pour être soumis au plasma de test (5).

3. Dispositif selon la revendication 2, **caractérisée en ce que** la source de plasma de test (3) comprend un tube de quartz étanche, dont une extrémité (3a) communique avec la chambre de procédés (1) ou la ligne de vide (2) à tester, et dont la paroi est traversée par le rayonnement lumineux (15) se propageant depuis le plasma de test (5) jusqu'aux moyens de mesure d'émission spectrale (7).

4. Dispositif selon la revendication 1, **caractérisé en ce que** la source de plasma de test (3) est déplaçable dans la chambre de procédés (1) ou la ligne de vide (2) entre un premier état à l'écart de l'échantillon de surface (6) à analyser pour laisser agir sur l'échantillon de surface (6) à analyser les gaz de la chambre de procédés (1) ou ligne de vide (2), et un second état au regard de l'échantillon de surface (6) à analyser pour faire agir sur l'échantillon de surface (6) à analyser le plasma de test (5), la source de plasma de test (3) étant reliée aux moyens de mesure d'émission spectrale (7) par une fibre optique flexible (19) autorisant les déplacements de la source de plasma de test (3).

5. Dispositif selon l'une quelconque des revendications 1 à 4, **caractérisé en ce qu'**il comprend des moyens de commande (9) pour recevoir, en provenance des moyens d'analyse (8), les informations relatives à la nature des atomes présents dans le plasma de test (5), pour commander la poursuite de l'étape de nettoyage tant que les atomes présents comprennent des atomes de dépôts, et pour interrompre l'étape de nettoyage dès que les atomes présents ne comprennent plus d'atomes de dépôt.

6. Procédé de nettoyage de chambres de procédés (1) ou lignes de vide (2), comprenant une étape de nettoyage dans laquelle on fait agir un ou plusieurs gaz de nettoyage assurant la décomposition des dépôts sur les parois intérieures des chambres de procédés (1) ou lignes de vide (2), **caractérisé en ce qu'**on prévoit une ou plusieurs étapes intermédiaires de contrôle dans lesquelles, au moyen d'un dispositif de contrôle selon l'une quelconque des revendications 1 à 5, on recherche la présence d'atomes de dépôt (6a) sur au moins un échantillon de surface (6) intérieure de la chambre de procédés (1) ou ligne de vide (2) à nettoyer en faisant agir un plasma de test (5) sur le dépôt (6a) de l'échantillon de surface (6).

7. Procédé selon la revendication 6, **caractérisé en ce que** les étapes intermédiaires de contrôle sont réalisées à des instants prédéterminés.

8. Procédé selon la revendication 7, **caractérisé en ce que** les instants sont choisis au voisinage de l'instant prévisible de fin de nettoyage.
